# EUROPEAN PATENT APPLICATION

(11) **EP 4 428 273 A1**
(43) Date of publication of application: **11.09.2024**
(21) Application number: 22890464.5
(22) Date of filing: 04.11.2022
(51) Int. Cl.: C30B 23/02, C30B 29/36, H01L 21/02

(54) **METHOD FOR MANUFACTURING SIC WAFER AND METHOD FOR PREPARING SIC INGOT**

(30) Priority: 05.11.2021 KR 20210151814
(71) Applicant: SENIC Inc., Seobuk-gu Cheonan-si, Chungcheongnam-do 31040 (KR)
(72) Inventor: KU, Kap Ryeol, Suwon-si Gyeonggi-do 16336 (KR); KYUN, Myung Ok, Suwon-si Gyeonggi-do 16327 (KR); KIM, Jung Gyu, Suwon-si Gyeonggi-do 16327 (KR); CHOI, Jung Woo, Suwon-si Gyeonggi-do 16328 (KR); SEO, Jung Doo, Hwaseong-si Gyeonggi-do 18496 (KR); PARK, Jong Hwi, Suwon-si Gyeonggi-do 16278 (KR)
(74) Representative: Isarpatent
(86) International application number: PCT/KR2022/017294
(87) International publication number: WO 2023/080733

(57) **Abstract**

Disclosed is a method of manufacturing a silicon carbide wafer. The method of manufacturing a silicon carbide wafer includes a step of disposing a silicon carbide block in a crucible; a step of sublimating a silicon carbide included in the silicon carbide block to form a silicon carbide ingot; and a step of processing the silicon carbide ingot.

## Description

### [Technical Field]

The present invention relates to a method of manufacturing a silicon carbide wafer and a method of manufacturing a silicon carbide ingot.

### [Background Art]

Single crystals of silicon carbide (SiC), silicon (Si), gallium nitride (GaN), sapphire (Al₂O₃), gallium arsenide (GaAs), aluminum nitride (AlN), and the like exhibit characteristics that cannot be expected from polycrystals thereof, and thus demands therefor in the industrial field are increasing.

Single crystal SiC has a large energy band gap and the maximum breakfield voltage and thermal conductivity thereof are superior to those of silicon (Si). In addition, the carrier mobility of single-crystal SiC is comparable to that of silicon, and the electron saturation drift rate and breakdown voltage thereof are also high. Due to these characteristics, single-crystal SiC is expected to be applied to semiconductor devices that require high efficiency, high breakdown voltage, and high capacity.

Silicon carbide is grown by liquid phase epitaxy (LPE), seed sublimation, chemical vapor deposition (CVD), or the like. Among the methods, seed sublimation is most widely used since the method can produce ingot-shaped silicon carbide with a high growth rate, and is also referred to as physical vapor transport (PVT).

As a method of preparing such a single crystal, for example, Japanese Patent Publication No. 2001-114599 discloses the growth of a single crystal ingot on a seed crystal 110 by, while heating by a heater in a vacuum vessel (heating furnace), into which argon gas can be introduced, maintaining the temperature of the seed crystal 110 at a temperature lower by 10 to 100°C than the temperature of raw material powder. In addition, there are attempts to produce single-crystal ingots having large diameters without substantial defects.

### [Disclosure]

### [Technical Problem]

Therefore, the present invention has been made in view of the above problems, and it is one object of the present invention to provide a method of manufacturing a silicon carbide wafer and silicon carbide ingot having improved mechanical properties, excellent crystallinity, and fewer defects with improved productivity.

### [Technical Solution]

In accordance with an aspect of the present invention, the above and other objects can be accomplished by the provision of a method of manufacturing a silicon carbide wafer, the method including: disposing a silicon carbide block in a crucible; sublimating a silicon carbide included in the silicon carbide block to form a silicon carbide ingot; and processing the silicon carbide ingot.

In an embodiment, the silicon carbide block may have an apparent volume of about 1 cm³ or more.

In an embodiment, the silicon carbide block may have a thermal conductivity of about 10 W/mK or more in at least one direction.

In an embodiment, a flow path through which a sublimated silicon carbide gas can move may be formed between an outer peripheral surface of the silicon carbide block and an inner surface of a reaction vessel.

In an embodiment, the silicon carbide block may be disposed to have a thermal conductivity of 10 W/mK or more in a horizontal direction.

In an embodiment, the silicon carbide block may include a flow path through which a sublimated silicon carbide gas can move.

In an embodiment, the flow path may be opened upward.

In an embodiment, at least a portion of the flow path may have an inner diameter that gradually increases toward an upper direction.

In an embodiment, the flow path may include: a first flow path having a first inner diameter; and a second flow path connected to the first flow path and configured to have a second inner diameter larger than the first inner diameter, wherein the second flow path is disposed on the first flow path.

In an embodiment, the silicon carbide block may include: a first silicon carbide block disposed in the reaction vessel; and a second silicon carbide block disposed on the first silicon carbide block.

In an embodiment, a flow path through which a sublimated silicon carbide gas can pass may be formed between the first silicon carbide block and the second silicon carbide block.

In an embodiment, a silicon carbide power may be disposed in the flow path.

In an embodiment, the silicon carbide block may have a cylindrical shape, a cone shape, a donut shape, or a polygonal pillar shape.

In an embodiment, the silicon carbide ingot may have a growth rate of 250 µm/hr or more.

In an embodiment, the silicon carbide block may include an open pore, and the silicon carbide block may have a porosity of 10 vol% to 50 vol%.

In accordance with another aspect of the present invention, there is provided a method of manufacturing a silicon carbide ingot, the method including: disposing a silicon carbide block in a crucible; disposing a seed crystal in the crucible; and sublimating silicon carbide included in the silicon carbide block to grow the seed crystal.

### [Advantageous effects]

A method of manufacturing a silicon carbide wafer according to an embodiment manufactures a silicon carbide ingot and a silicon carbide wafer by sublimating silicon carbide included in a silicon carbide block.

A raw material for forming the silicon carbide ingot has a block shape, thereby having high thermal conductivity. In particular, the silicon carbide block can be disposed to have high thermal conductivity in a horizontal direction.

Accordingly, heat generated in the crucible can be easily transferred to the inside of the crucible. Accordingly, a uniform temperature gradient can be formed over the entire raw material disposed inside the crucible.

Therefore, the method of manufacturing the silicon carbide wafer and the method of manufacturing the silicon carbide ingot according to embodiments can easily control the temperature for each position in the crucible. Therefore, the method of manufacturing the silicon carbide wafer and the method of manufacturing the silicon carbide ingot according to embodiments can prevent crystallinity distortion or various defects due to temperature non-uniformity. Accordingly, the method of manufacturing the silicon carbide wafer and the method of manufacturing the silicon carbide ingot according to embodiments can provide improved crystallinity and mechanical strength.

In addition, the silicon carbide block has high thermal conductivity, and thus, can efficiently transfer heat generated from the crucible to the raw material disposed inside the crucible. That is, the silicon carbide block can be a raw material for forming the silicon carbide wafer and a heat transfer medium for transferring heat to the inside. Therefore, the methods of manufacturing the silicon carbide wafer and the silicon carbide ingot according to embodiments can improve a sublimation rate of silicon carbide. In addition, since the silicon carbide block has high a thermal conductivity, the temperature of the raw material can be maintained high even if the temperature near the seed crystal is low.

Therefore, the methods of manufacturing the silicon carbide wafer and the silicon carbide ingot according to embodiments can not only improve the sublimation rate of silicon carbide, but also improve the deposition rate on a seed crystal. Therefore, the methods of manufacturing the silicon carbide wafer and the silicon carbide ingot according to embodiments can provide an improved growth rate.

In addition, as the diameter of the silicon carbide wafer increases, the inner diameter of the crucible body should also increase. Here, since the silicon carbide block has high thermal conductivity, the temperature inside the crucible body can be efficiently controlled even if the inner diameter of the crucible body increases. Accordingly, a large-diameter silicon carbide wafer having improved performance can be efficiently produced by the method of manufacturing the silicon carbide wafer and the method of manufacturing the silicon carbide ingot according to embodiments.

### [Description of Drawings]

FIG. 1 is an exploded perspective view illustrating a crucible assembly and a silicon carbide block according to a first embodiment.
FIG. 2 is a sectional view illustrating a shape in which the silicon carbide block is disposed in the crucible assembly according to the first embodiment.
FIG. 3 is a sectional view illustrating an ingot growth apparatus for manufacturing a silicon carbide ingot according to the first embodiment.
FIG. 4 is a sectional view illustrating a state in which a silicon carbide block is disposed in a crucible assembly according to a second embodiment.
FIG. 5 is a sectional view illustrating a state in which a silicon carbide block is disposed in a crucible assembly according to a third embodiment.
FIG. 6 is a perspective view illustrating a silicon carbide block according to a fourth embodiment.
FIG. 7 is a sectional view illustrating a state in which a silicon carbide block is disposed in a crucible assembly according to the fourth embodiment.
FIG. 8 is a perspective view illustrating a silicon carbide block according to a fifth embodiment.
FIG. 9 is a sectional view illustrating a state in which a silicon carbide block is disposed in the crucible assembly according to the fifth embodiment.
FIG. 10 is a sectional view in which a silicon carbide block is disposed in a crucible assembly according to a sixth embodiment.
FIG. 11 is a perspective view illustrating a silicon carbide block 100 according to a seventh embodiment.
FIG. 12 is a sectional view illustrating a state in which a silicon carbide block is disposed in a crucible assembly according to the seventh embodiment.
FIG. 13 is a sectional view illustrating a state in which a silicon carbide block is disposed in a crucible assembly according to an eighth embodiment.
FIG. 14 is a sectional view illustrating a state in which a silicon carbide block is disposed in a crucible assembly according to a ninth embodiment.
FIG. 15 is a sectional view illustrating a cross-section of a silicon carbide block according to a tenth embodiment.

### [Best Mode]

Hereinafter, embodiments of the present invention will be described in detail in such a manner that the invention may be easily carried out by those of ordinary skill in the art to which the present disclosure pertains. The present invention may, however, be embodied in many different forms and should not be construed as being limited to the embodiments set forth herein.

In the present specification, when a component is referred to as "including" another component, unless otherwise specifically stated, this does not preclude other components and also may mean that other components may be further included.

In the present specification, when a component is referred to as being "connected" with another component, it includes not only a case where it is directly connected, but also a case where it is connected with another component present therebetween.

In the present specification, it will be understood that when B is referred to as being "on" A, B is directly on A or B is on A with an intervening layer disposed therebetween, and it should not be construed as being limited to the case in which B is directly on a surface of A.

In the present specification, the term such as "combination(s) thereof" included in an expression of the Markush form means a mixture or combination of one or more elements selected from the group consisting of elements described in the expression of the Markush form and includes one or more elements selected from the group consisting of the elements.

In the present specification, "A and/or B" means "A, B, or A and B."

An expression used in the singular is interpreted to include an expression in the singular or in the plural unless the context clearly indicates otherwise.

Further, the respective embodiments may be combined with each other so long as they do not technically interfere with each other.

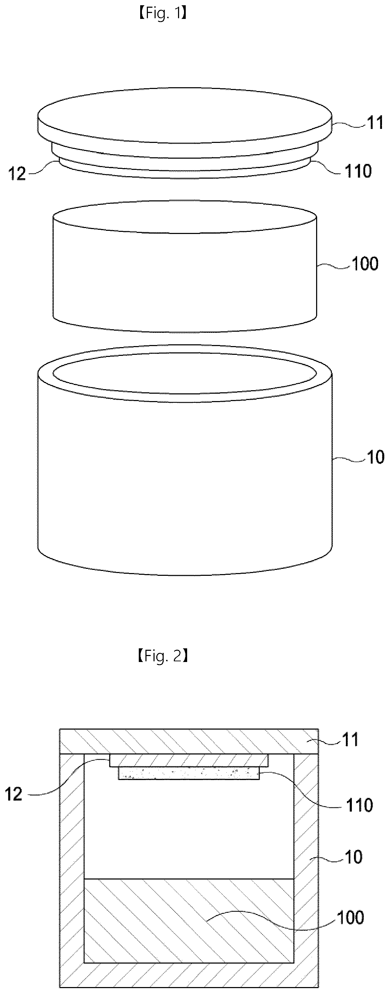

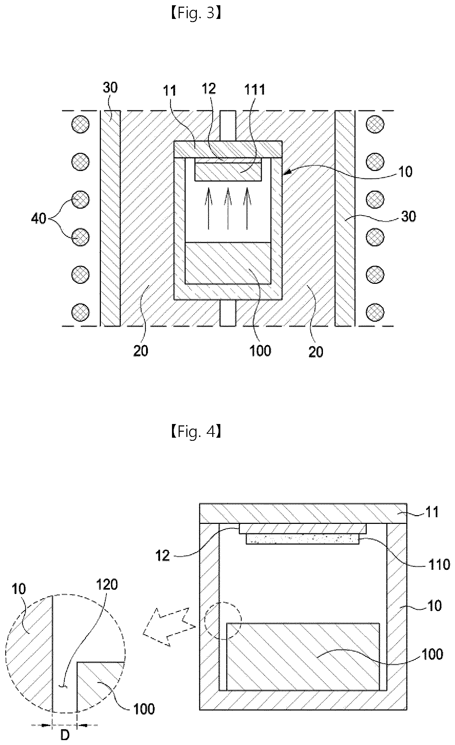

FIG. 1 is an exploded perspective view illustrating a crucible assembly and a silicon carbide block 100 according to a first embodiment. FIG. 2 is a sectional view illustrating a shape in which the silicon carbide block 100 is disposed in the crucible assembly according to the first embodiment. FIG. 3 is a sectional view illustrating an ingot growth apparatus for manufacturing a silicon carbide ingot 111 according to the first embodiment.

As shown in FIGS. 1 to 3, the silicon carbide ingot growth apparatus for manufacturing the silicon carbide ingot 111 and a silicon carbide wafer includes a crucible body 10, a crucible cover 11, a seed crystal holder 12, a thermal insulator 20, a reaction chamber 30 and an induction coil 40.

There is a space inside the crucible body 10. The crucible body 10 accommodates a raw material for growing the silicon carbide ingot 111. The crucible body 10 includes an accommodating part that is a space for accommodating the raw material. In addition, the crucible body 10 may have a cylindrical shape with an opening on the top thereof. The crucible body 10 may have a structure capable of loading a silicon carbide raw material therein.

The crucible body 10 may include graphite. The crucible body 10 may be made of graphite. The crucible body 10 may be a graphite crucible. The crucible body 10 may be a conductor. The crucible body 10 may be heated by resistance heat that is induced by an induced current generated by the induction coil 40.

The crucible body 10 may have a density of 1.70 g/ cm³ to 1.90 g/ cm³.

The crucible cover 11 covers the inlet of the crucible body 10. The crucible cover 11 may have a circular plate shape. The crucible cover 11 may completely cover the inlet of the crucible body 10. The crucible cover 11 may have a shape corresponding to the inlet of the crucible body 10.

The crucible cover 11 may have a thickness of about 10 mm to about 50 mm. The crucible cover 11 may have a thickness of about 15 mm to about 40 mm.

The crucible cover 11 may have a density of 1.70 g/ cm³ to 1.90 g/ cm³. The crucible cover 11 may include graphite. The crucible cover 11 may be substantially made of graphite. The crucible cover 11 may have a shape of completely covering the opening of the crucible body 10.

The crucible cover 11 may partially cover the opening of the crucible body 10, or a crucible cover 11 including a through hole (not shown) may be applied. In this case, the speed of vapor transport in the crystal growth atmosphere to be described below may be controlled.

The crucible body 10 and the crucible cover 11 may form a crucible assembly. The seed crystal 110 is disposed in the crucible assembly. The seed crystal holder 12 may be disposed in the crucible body 10. In addition, the seed crystal holder 12 may be disposed under the crucible cover 11. That is, the seed crystal holder 12 may be disposed on a lower surface of the crucible cover 11. The seed crystal holder 12 may be integrally formed with the crucible cover 11.

The seed crystal holder 12 may include graphite. The seed crystal holder 12 may be made of graphite.

In addition, the seed crystal holder 12 may have a thickness of about 1 mm to about 20 mm. The seed crystal holder 12 may have a thickness of about 2 mm to about 10 mm.

The thermal insulator 20 is disposed around the crucible assembly. The thermal insulator 20 surrounds the crucible assembly. The thermal insulator 20 surrounds the outer periphery of the crucible body 10. In addition, the thermal insulator 20 may be disposed on the crucible cover 11. In addition, the thermal insulator 20 may be disposed also under the crucible body 10.

The thermal insulator 20 may affect a temperature gradient inside the crucible body 10 or inside the reaction vessel in a growth atmosphere. Particularly, the thermal insulator 20 may include a graphite thermal insulator 20, and more particularly the thermal insulator 20 may include rayon-based graphite felt or pitch-based graphite felt.

The thermal insulator 20 may have a density of about 0.12 g/cc to about 0.30 g/cc. The thermal insulator 20 may have a density of about 0.13 g/cc to about 0.25 g/cc. The thermal insulator 20 may have a density of about 0.14 g/cc to about 0.20 g/cc.

When the density of the thermal insulator 20 is within the above range, the silicon carbide ingot 111 may be appropriately convexly formed, and 6H-SiC polymorphism occurs so that the quality of the silicon carbide ingot 111 may be prevented from being deteriorated.

When the density of the thermal insulator 20 is within the above range, the growth rate of edges may be appropriately increased, and cracking of the silicon carbide ingot 111 may be suppressed.

By using the thermal insulator 20 having a density of 0.12 g/cc to 0.30 g/cc, the quality of ingot may be further improved. In addition, by using the thermal insulator 20 having a density of 0.14 g/cc to 0.20 g/cc, the crystal growth atmosphere may be well controlled in an ingot growth process, and it is better for growing an ingot of excellent quality.

The thermal insulator 20 may have a porosity of about 73 vol% to about 95 vol%. The thermal insulator 20 may have a porosity of about 76 vol% to about 93 vol%. The thermal insulator 20 may have a porosity of about 81 vol% to about 91 vol%. By applying the thermal insulator 20 having a porosity within the ranges, the frequency of occurrence of ingot cracks may be further reduced.

The thermal insulator 20 may have a compressive strength of about 0.21 Mpa or more. The thermal insulator 20 may have a compressive strength of about 0.49 Mpa or more. The thermal insulator 20 may have a compressive strength of about 0.78 MPa or more. In addition, the thermal insulator 20 may have a compressive strength of about 3 MPa or less or a compressive strength of about 25 MPa or less. When the thermal insulator 20 has a compressive strength within the range, thermal/mechanical stability is excellent and the probability of ash generation is reduced, so that a SiC ingot of superior quality may be manufactured.

The thermal insulator 20 may be applied to a thickness of about 20 mm or more or may be applied to a thickness of about 30 mm or more. In addition, the thermal insulator 20 may be applied to a thickness of about 150 mm or less, may be applied to a thickness of about 120 mm or less, and may be applied to a thickness of about 80 mm or less. When the thermal insulator 20 is applied to a thickness within the range, thermal insulating effect may be sufficiently obtained without unnecessary waste of the thermal insulator 20.

The thermal insulator 20 may have a density of 0.12 g/cc to 0.30 g/cc and a porosity of 72 vol% to 90 vol%. When such a thermal insulator 20 is applied, the ingot may be suppressed from growing in a concave or excessively convex shape, and the deterioration of polymorph quality or the occurrence of cracks in the ingot may be reduced.

The reaction chamber 30 may accommodate the crucible body 10, the crucible cover 11, the seed crystal holder 12 and the thermal insulator 20. The reaction chamber 30 may control an atmosphere inside the crucible body 10. The reaction chamber 30 may control a gas atmosphere inside the crucible body 10 and a pressure inside the crucible body 10. That is, the reaction chamber 30 may accommodate the crucible body 10, etc., and may control overall reaction conditions by adjusting the gas atmosphere and pressure thereinside.

The induction coil 40 is disposed outside the reaction chamber 30. The induction coil 40 may generate an induction current. The induction coil 40 may generate the alternating current to generate an induction current in the crucible body 10. That is, the induction coil 40 may be a heating means for heating the crucible body 10.

A silicon carbide raw material for forming the silicon carbide ingot 111 is disposed in the crucible body 10. The silicon carbide raw material includes the silicon carbide block 100. Most of the silicon carbide raw material may be composed of the silicon carbide block 100. For example, the weight of the silicon carbide block 100 may be about 70 % by weight or more based on the total weight of the silicon carbide raw material. The weight of the silicon carbide block 100 may be about 80 % by weight or more based on the total weight of the silicon carbide raw material. The weight of silicon carbide block 100 may be about 90 % by weight or more based on the total weight of the silicon carbide raw material.

The silicon carbide block 100 may have a block shape. One silicon carbide block 100 may be included in the crucible body 10. Alternatively, a plurality of silicon carbide blocks 100 may be included in the crucible body 10.

The silicon carbide block 100 may have an apparent volume of about 1 cm³ or more. The silicon carbide block 100 may have an apparent volume of about 5 cm³ or more. The silicon carbide block 100 may have an apparent volume of about 10 cm³ or more. The silicon carbide block 100 may have an apparent volume of about 20 cm³ or more. The silicon carbide block 100 may have an apparent volume of about 100 cm³ or more. The silicon carbide block 100 may have an apparent volume of about 1000 cm³ or more. The silicon carbide block 100 may have an apparent volume of about 5000 cm³ or more. The apparent volume of the silicon carbide block 100 is smaller than the volume of the inner space of the crucible body 10. The silicon carbide block 100 may have an apparent volume of about 1 cm³ or less.

Here, the apparent volume may be measured based on the outer shape of the silicon carbide block 100. That is, the apparent volume may be a volume measured on the assumption that there are no pores in the silicon carbide block 100. That is, the sum of the volume of silicon carbide in the silicon carbide block 100 and the volume of pores in the silicon carbide block 100 may be the apparent volume.

The silicon carbide block 100 may have a column shape such as a circular column or a polygonal column. The silicon carbide block 100 may have a polyhedral shape. The silicon carbide block 100 may have a plate shape. In addition, the silicon carbide block 100 may have a cone shape such as a cone or a polygonal cone. The silicon carbide block 100 may have a donut shape. In addition, the silicon carbide block 100 may have a partially cut shape.

The silicon carbide block 100 may be a single crystal or a polycrystal. In addition, the silicon carbide block 100 may be a sintered body. That is, the silicon carbide block 100 may have a block shape formed by sintering silicon carbide particles and the like.

In addition, the silicon carbide block 100 may be formed by depositing silicon carbide by chemical vapor deposition. The silicon carbide block 100 may be formed by depositing silicon carbide by physical vapor deposition.

The silicon carbide block 100 may include α-phase silicon carbide or β-phase silicon carbide.

The silicon carbide block 100 may have high thermal conductivity. The silicon carbide block 100 may have a thermal conductivity of about 10 W/mK or more. The silicon carbide block 100 may have a thermal conductivity of about 20 W/mK or more. The silicon carbide block 100 may have a thermal conductivity of about 30 W/mK or more. The silicon carbide block 100 may have a thermal conductivity of about 50 W/mK or more. The silicon carbide block 100 may have a thermal conductivity of about 70 W/mK or more. The silicon carbide block 100 may have a thermal conductivity of about 100 W/mK or more. The silicon carbide block 100 may have a thermal conductivity of about 110 W/mK or more. An upper limit of the thermal conductivity of the silicon carbide block 100 may be about 2000 W/mK.

In addition, the silicon carbide block 100 may have anisotropic thermal conductivity. Here, the silicon carbide block 100 may be disposed to have a thermal conductivity of about 10 W/mK or more in a horizontal direction. The silicon carbide block 100 may be disposed to have a thermal conductivity of about 20 W/mK or more in a horizontal direction. The silicon carbide block 100 may be disposed to have a thermal conductivity of about 30 W/mK or more in a horizontal direction. The silicon carbide block 100 may be disposed to have a thermal conductivity of about 40 W/mK or more in a horizontal direction. The silicon carbide block 100 may be disposed to have a thermal conductivity of about 50 W/mK or more in a horizontal direction. The silicon carbide block 100 may be disposed to have a thermal conductivity of about 70 W/mK or more in a horizontal direction. The silicon carbide block 100 may be disposed to have a thermal conductivity of about 100 W/mK or more in a horizontal direction. The silicon carbide block 100 may be disposed to have a thermal conductivity of about 110 W/mK or more in a horizontal direction. An upper limit of the thermal conductivity of the silicon carbide block 100 in a horizontal direction may be about 2000 W/mK.

Since the silicon carbide block 100 has a thermal conductivity within the range, heat generated from the crucible body 10 may be efficiently transferred to the center of an inner space of the crucible body 10. Accordingly, a temperature gradient in the horizontal direction in the crucible body 10 may be minimized. Therefore, the methods of manufacturing the silicon carbide ingot and the silicon carbide wafer may effectively control the temperature inside the crucible body 10. Therefore, the silicon carbide ingot 111 produced from the silicon carbide block 100 may have a fast growth rate and improved crystal properties.

A diameter of the silicon carbide block 100 may be substantially the same as an inner diameter of the crucible body 10. Accordingly, the silicon carbide block 100 may be almost completely filled in a lower part of the crucible body 10. In addition, at least a portion of an outer surface of the silicon carbide block 100 may be in direct contact with an inner surface of the crucible body 10. Among an outer peripheral surface of the silicon carbide block 100, a portion in contact with the inner surface of the crucible body 10 may be about 20% or more.

When the crucible body 10 is partially in contact with the silicon carbide block 100 as described above, heat generated from the crucible body 10 may be easily transferred to the silicon carbide block 100.

The silicon carbide wafer according to the embodiment may be manufactured as follows.

First, the silicon carbide ingot 111 may be manufactured. The silicon carbide ingot 111 may be manufactured by applying a physical vapor transport method (PVT) so as to have a large area and few defects.

The method of manufacturing the silicon carbide ingot according to an embodiment may include a preparation step, a raw material-loading step and a growth step.

The preparation step is a step of preparing a crucible assembly including the crucible body 10 having an inner space; and the crucible cover 11 for covering the crucible body 10.

The raw material-loading step includes a step of loading a silicon carbide raw material including the silicon carbide block 100 in the crucible assembly and arranging the seed crystal 110 on the raw material at a predetermined distance from the raw material.

To manufacture the silicon carbide ingot 111, the seed crystal 110 is prepared. The seed crystal 110 may be any one of wafers to which an off-angle, which is an angle selected in a range of 0 to 8 degrees with respect to a plane [0001], is applied.

The seed crystal 110 may be a 4H SiC ingot that is a substantially single crystal with minimal defects or polymorphic incorporation. The silicon carbide seed crystal 110 may be substantially made of 4H SiC.

The seed crystal 110 may have a diameter of 4 inches or more, a diameter of 5 inches or more, further a diameter of 6 inches or more. More particularly the seed crystal 110 may have a diameter of 4 to 12 inches, a diameter of 4 to 10 inches, or a diameter of 6 to 8 inches.

The seed crystal 110 is attached to the seed crystal holder 12. The seed crystal holder 12 includes graphite. The seed crystal holder 12 may be made of graphite. The seed crystal holder 12 may include anisotropic graphite. In more detail, the seed crystal holder 12 may be made of anisotropic graphite.

The seed crystal holder 12 may have high thermal conductivity. The seed crystal holder 12 may have a high thermal conductivity in a horizontal direction. The seed crystal holder 12 may have a thermal conductivity of about 100 W/mK or more in at least one direction. The seed crystal holder 12 may have a thermal conductivity of about 110 W/mK or more in at least one direction.

In addition, the crucible cover 11 and the seed crystal holder 12 may be integrally formed with each other. In addition, the crucible cover 11 and the seed crystal holder 12 may be made of graphite. Here, the crucible cover 11 and the seed crystal holder 12 may have a thermal conductivity of about 100 W/mK or more in at least one of horizontal directions. Here, the crucible cover 11 and the seed crystal holder 12 may have a thermal conductivity of about 110 W/mK or more in at least one of horizontal directions. In addition, the crucible cover 11 and the seed crystal holder 12 may have substantially the same thermal conductivity along directions.

In addition, the seed crystal 110 and the seed crystal holder 12 are adhered to each other by an adhesive layer. The adhesive layer includes a graphite filler and a carbide such as a phenol resin. The adhesive layer may have a low porosity.

The seed crystal 110 may be disposed such that surface C faces downward.

Next, the raw material including the silicon carbide block 100 for manufacturing the silicon carbide ingot 111 is loaded in the crucible.

In the raw material-loading step, the crucible assembly may have a weight ratio (Rw) of 0.3 times to 0.8 times when the weight of the raw material is 1. Here, the weight of the crucible assembly means the weight of the crucible assembly excluding the raw material. Particularly, regardless of whether the seed crystal holder 12 is applied to the crucible assembly, the weight of the crucible assembly is a value excluding the weight of the raw material fed into the crucible assembly assembled to include the seed crystal 110.

The growth step is a step of adjusting the inner space of the crucible body 10 to have a crystal growth atmosphere such that the raw material is vapor-transferred to and deposited on the seed crystal 110 and the silicon carbide ingot 111 grown from the seed crystal 110 is prepared.

The growth step includes a process of adjusting the inner space of the crucible assembly to have a crystal growth atmosphere. Particularly, the growth step may be performed in a manner of wrapping the crucible assembly with the thermal insulator 20 to prepare a reaction vessel (not shown) including the crucible assembly and the thermal insulator 20 surrounding the crucible assembly, and placing the reaction vessel in a reaction chamber such as a quartz tube, and then heating the crucible, etc. with a heating means.

The reaction vessel is located in a reaction chamber 42 to induce the inner space of the crucible body 10 through the induction coil 40 to have a temperature suitable for a crystal growth atmosphere. This temperature is one of important factors for the crystal growth atmosphere, and a more suitable crystal growth atmosphere is formed by controlling conditions such as pressure and gas movement. The thermal insulator 20 is positioned between the reaction chamber 42 and the reaction vessel to more easily help the formation and control of the crystal growth atmosphere.

The crystal growth atmosphere may be realized through heat generated in the crucible by the induction coil 40 outside the reaction chamber 42

Air may be removed by reducing pressure simultaneously or separately with heating of the crucible, and the process may be performed in a reduced pressure atmosphere and/or an inert atmosphere (e.g., Ar atmosphere, N₂ atmosphere or a mixed atmosphere thereof).

The crystal growth atmosphere induces the growth of silicon carbide crystal by vapor-transporting the raw material to the surface of the seed crystal 110 to grow into the ingot 111.

To the crystal growth atmosphere, a growth temperature of 2100°C to 2450°C and a growth pressure of 1 torr to 100 torr may be applied. When these temperature and pressure conditions are applied, the silicon carbide ingot 111 may be more efficiently manufactured.

Particularly, to the crystal growth atmosphere, crucible's upper and lower surface temperatures of 2100°C to 2450°C as a growth temperature; and a growth pressure of 1 torr to 50 torr may be applied. More specifically, a crucible's upper and lower surface temperatures of 2150°C to 2450°C as a growth temperature; and a growth pressure of 1 torr to 40 torr may be applied.

More particularly, a crucible's upper and lower surface temperatures of 2150 to 2350°C as a growth temperature; and a growth pressure of 1 torr to 30 torr may be applied.

By applying the above-described crystal growth atmosphere, there are advantages in manufacturing a silicon carbide ingot of higher quality using the manufacturing method of the present invention.

The silicon carbide ingot contains 4H SiC, and the surface thereof may be convex or flat.

When the surface of the silicon carbide ingot is formed in a concave shape, other polymorphs such as 6H-SiC may be mixed in addition to the intended 4H-SiC crystal, which may degrade the quality of the silicon carbide ingot 111. In addition, when the surface of the silicon carbide ingot 111 is formed in an excessively convex shape, cracks may occur in the ingot itself, or the crystal may be broken when processing into a wafer.

Here, whether the silicon carbide ingot is an excessively convex ingot is determined based on the degree of curvature, and the silicon carbide ingot 111 manufactured in the present specification has a curvature of 20 mm or less.

The curvature is evaluated by placing a sample, where the growth of the silicon carbide ingot has been completed, on a platen and measuring the heights of the center and edge of the ingot with a height gauge based on a rear surface of the ingot to evaluate as a value of (center height - edge height). A positive value of curvature means convex, a value of 0 thereof means flatness, and a negative value thereof means concave.

Particularly, the silicon carbide ingot may have a convex or flat surface, and may have a curvature of 0 mm to 14 mm, a curvature of 0 mm to 11 mm, or a curvature of 0 mm to 8 mm. A silicon carbide ingot having a curvature within such a range may make wafer processing easier and reduce cracking.

The silicon carbide ingot may be a substantially single-crystal 4H SiC ingot with minimal defects or polymorph incorporation. The silicon carbide ingot is substantially made of 4H SiC and may have a convex or flat surface.

The silicon carbide ingot may provide a higher quality silicon carbide wafer by reducing defects that may occur in a silicon carbide ingot.

The silicon carbide ingot manufactured by the method of the present specification may reduce a pit to be formed on the surface thereof. Particularly, a pit included in the surface of an ingot having a diameter of 4 inches or more may be 10 k/cm² or less.

In the specification, for surface fit measurement of the silicon carbide ingot, a total of 5 parts including one part of the central part excluding a facet on the surface of the ingot and four places in the 3 o'clock, 6 o'clock, 9 o'clock, and 12 o'clock positions located within about 10 mm from the edge of the silicon carbide ingot toward the center are observed under a microscope, and a pit per unit area (1 cm²) at each location is measured, and then an average value thereof is evaluated.

For example, the silicon carbide ingot is subjected to external grinding equipment to trim the outer edge of the ingot (external grinding), cut to a certain thickness (slicing), and then edge grinding, surface grinding, polishing, etc. may be processed.

The slicing step is a step of preparing a sliced crystal by slicing the silicon carbide ingot to have a certain off-angle. The off-angle is based on the plane [0001] in 4H SiC. The off-angle may be an angle selected from 0 to 15 degrees, an angle selected from 0 to 12 degrees, and an angle selected from 0 to 8 degrees.

The slicing may be any slicing method that is generally applied to wafer manufacturing. For example, cutting using a diamond wire or a wire to which a diamond slurry is applied, cutting using a blade or wheel to which diamond, etc. is partially applied, etc. may be applied, without being limited thereto.

The thickness of the sliced crystal may be adjusted in consideration of the thickness of the wafer to be manufactured and may be sliced to an appropriate thickness in consideration of the thickness after being polished in a polishing step to be described below.

The polishing step is a step of polishing the sliced crystal to a thickness of 300 to 800 um to form a silicon carbide wafer.

To the polishing step, a polishing method generally applied to wafer manufacturing may be applied. For example, after a process such as lapping and/or grinding is performed, polishing, etc. may be applied.

In the method of manufacturing the silicon carbide wafer according to an embodiment, silicon carbide included in the silicon carbide block 100 is sublimated, thereby manufacturing a silicon carbide ingot and a silicon carbide wafer.

The raw material for forming the silicon carbide ingot has a block shape, thereby having high thermal conductivity. In particular, the silicon carbide block 100 may be disposed to have high thermal conductivity in a horizontal direction.

Accordingly, heat generated in the crucible may be easily transferred to the inside of the crucible. Accordingly, a uniform temperature gradient may be formed over the entire raw material disposed inside the crucible.

Therefore, the method of manufacturing the silicon carbide wafer and the method of manufacturing the silicon carbide ingot according to embodiments may easily control the temperature for each position in the crucible. Therefore, the method of manufacturing the silicon carbide wafer and the method of manufacturing the silicon carbide ingot according to embodiments may prevent crystallinity distortion or various defects due to temperature non-uniformity. Accordingly, the method of manufacturing the silicon carbide wafer and the method of manufacturing the silicon carbide ingot according to embodiments may provide improved crystallinity and mechanical strength.

In addition, the silicon carbide block 100 has high thermal conductivity, and thus, may efficiently transfer heat generated from the crucible to the raw material disposed inside the crucible. That is, the silicon carbide block 100 may be a raw material for forming the silicon carbide wafer and a heat transfer medium for transferring heat to the inside. Therefore, the methods of manufacturing the silicon carbide wafer and the silicon carbide ingot according to embodiments may improve a sublimation rate of silicon carbide. In addition, since the silicon carbide block 100 has high a thermal conductivity, the temperature of the raw material may be maintained high even if the temperature near the seed crystal 110 is low.

The silicon carbide block 100 has high thermal conductivity and may be disposed to have high thermal conductivity in a horizontal direction. Accordingly, the raw material within the crucible body 10 may have high thermal conductivity in the horizontal direction as a whole. Therefore, the methods of manufacturing the silicon carbide ingot and the silicon carbide wafer may lower a temperature gradient in the horizontal direction. In addition, since a temperature difference between a central part of the raw material and the outer part thereof is not large, a temperature difference between the vicinity of the seed crystal 110 and an upper part of the raw material may be large. That is, a temperature gradient in a vertical direction within the crucible body 10 may increase. Accordingly, the sublimation rate of silicon carbide in the vicinity of the raw material may be increased, and the deposition rate on the seed crystal 110 may also be increased.

Therefore, the methods of manufacturing the silicon carbide wafer and the silicon carbide ingot according to embodiments may not only improve the sublimation rate of silicon carbide, but also improve the deposition rate on a seed crystal 110. Therefore, the methods of manufacturing the silicon carbide wafer and the silicon carbide ingot according to embodiments may provide an improved growth rate.

In addition, as the diameter of the silicon carbide wafer increases, the inner diameter of the crucible body 10 should also increase. Here, since the silicon carbide block 100 has high thermal conductivity, the temperature inside the crucible body 10 may be efficiently controlled even if the inner diameter of the crucible body 10 increases. Accordingly, a large-diameter silicon carbide wafer having improved performance may be efficiently produced by the method of manufacturing the silicon carbide wafer and the method of manufacturing the silicon carbide ingot according to embodiments.

FIG. 4 is a sectional view illustrating a state in which a silicon carbide block is disposed in a crucible assembly according to a second embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIG. 4, a first flow path 120 may be formed between the silicon carbide block 100 and the inner surface of the crucible body 10. The first flow path 120 may be an empty space between the outer peripheral surface of the silicon carbide block 100 and the inner surface of the crucible body 10. That is, the first flow path 120 may be formed such that the outer peripheral surface of the silicon carbide block 100 and the inner surface of the crucible body 10 are spaced apart from each other.

A width D of the first flow path 120 may be about 0.1 mm to about 30 mm. The width D of the first flow path 120 may be about 0.5 mm to about 20 mm. The width D of the first flow path 120 may be about 1 mm to about 10 mm.

The first flow path 120 may be formed entirely on the outer peripheral surface of the silicon carbide block 100. The first flow path 120 may be partially formed on the outer peripheral surface of the silicon carbide block 100. The first flow path 120 may be formed on a region of about 10% to about 90% of the outer peripheral surface of the silicon carbide block 100. The first flow path 120 may be formed on a region of about 20% to about 80% of the outer peripheral surface of the silicon carbide block 100. The first flow path 120 may be formed on a region of about 30% to about 70% of the outer peripheral surface of the silicon carbide block 100.

The first flow path 120 may extend from a lower part of the silicon carbide block 100 to an upper part thereof. The first flow path 120 may extend from the bottom of the crucible body 10 toward the upper part of the crucible body 10. The first flow path 120 may extend vertically.

Through the first flow path 120, a silicon carbide gas sublimated from the outer peripheral surface of the silicon carbide block 100 and the lower part of the silicon carbide block 100 may effectively move to the upper part of the crucible body 10. Accordingly, the methods of manufacturing the silicon carbide ingot and the silicon carbide wafer may provide an improved growth rate.

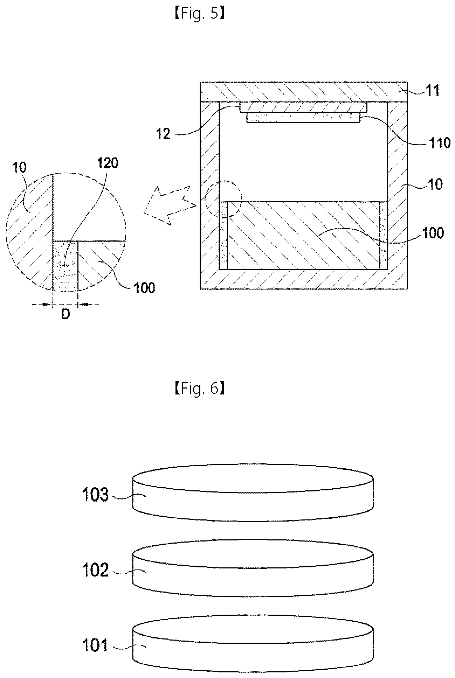

FIG. 5 is a sectional view illustrating a state in which a silicon carbide block is disposed in a crucible assembly according to a third embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

As shown in FIG. 5, the first flow path 120 includes a silicon carbide power. The first flow path 120 may be filled with the silicon carbide power. That is, the silicon carbide power may be packed in the first flow path 120.

The silicon carbide power includes silicon carbide. The silicon carbide power may be formed of silicon carbide. The silicon carbide powder having a particle size of about 75 µm or less may be included in an amount of 15 % by weight or less, 10 % by weight or less, or 5 % by weight or less, based on the total weight of the raw material.

In addition, the silicon carbide power may have a particle diameter D50 of about 130 µm to about 400 µm. The silicon carbide power may have D50 of about 170 µm to about 300 µm.

The silicon carbide power may be disposed between the silicon carbide block 100 and the crucible body 10 and may transfer heat generated from the crucible body 10 to the silicon carbide block 100. That is, the silicon carbide power may fill a gap between the silicon carbide block 100 and the crucible body 10 and may improve heat transfer characteristics between the crucible body 10 and the silicon carbide block 100. In addition, since the first flow path 120 is filled with the silicon carbide power, silicon carbide sublimated into spaces between particles included in the silicon carbide power may move efficiently.

Therefore, the methods of manufacturing the silicon carbide ingot and the silicon carbide wafer according to embodiments may provide an ingot and wafer with improved growth rate, fewer defects, and improved crystal properties.

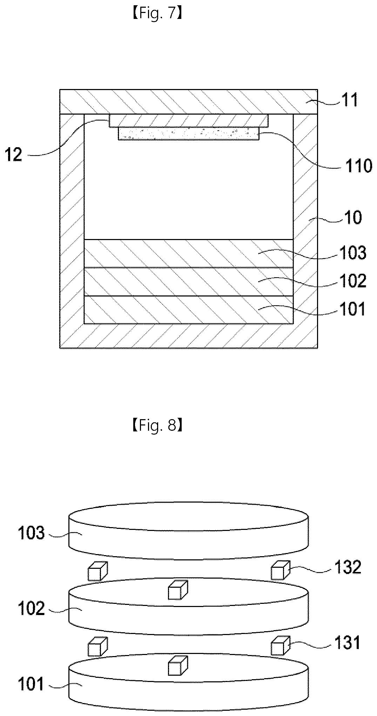

FIG. 6 is a perspective view illustrating a silicon carbide block according to a fourth embodiment. FIG. 7 is a sectional view illustrating a state in which a silicon carbide block is disposed in a crucible assembly according to the fourth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

As shown in FIGS. 6 and 7, the silicon carbide block may include a first silicon carbide block 101, a second silicon carbide block 102 and a third silicon carbide block 103.

The first silicon carbide block 101, the second silicon carbide block 102 and the third silicon carbide block 103 may be sequentially stacked.

That is, the first silicon carbide block 101 may be disposed on a bottom surface of the crucible body 10, the second silicon carbide block 102 may be disposed on the first silicon carbide block 101, and the third silicon carbide block 103 may be disposed on the second silicon carbide block 102.

The first silicon carbide block 101, the second silicon carbide block 102 and the third silicon carbide block 103 may have various shapes other than the plate shape shown in FIG. 6, as described above.

In addition, the number of silicon carbide blocks disposed in the crucible body 10 may be 3 or more. That is, several silicon carbide blocks may be stacked and disposed in the crucible body 10. In addition, silicon carbide blocks 100 may have the same or different shapes.

The methods of manufacturing the silicon carbide ingot and the silicon carbide wafer according to the embodiment may use a plurality of silicon carbide blocks as a silicon carbide raw material, thereby stacking the raw material to a desired height. In addition, the methods of manufacturing the silicon carbide ingot and the silicon carbide wafer according to the embodiment may appropriately dispose several silicon carbide blocks in the crucible body 10, thereby efficiently designing overall thermal conductivity. In addition, the methods of manufacturing the silicon carbide ingot and the silicon carbide wafer according to the embodiment may form a flow path, through which sublimated silicon carbide gas efficiently moves to the seed crystal 110, by disposing several silicon carbide blocks.

Therefore, the methods of manufacturing the silicon carbide ingot and the silicon carbide wafer according to the embodiment may provide an ingot and wafer with improved growth rate, fewer defects, and improved crystal properties.

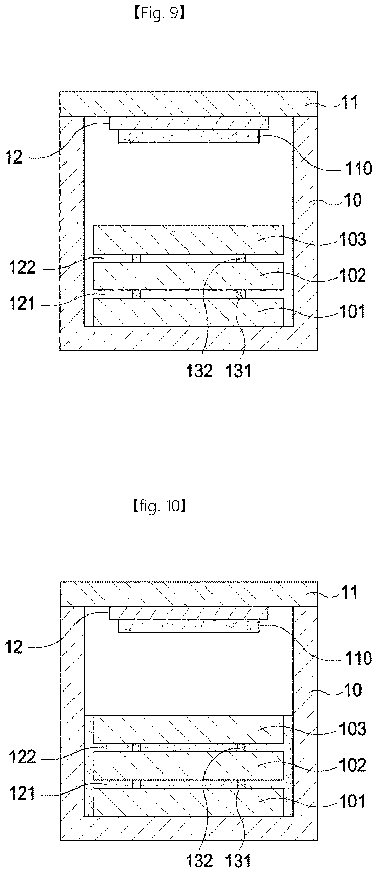

FIG. 8 is a perspective view illustrating a silicon carbide block according to a fifth embodiment. FIG. 9 is a sectional view illustrating a state in which a silicon carbide block is disposed in the crucible assembly according to the fifth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

As shown in FIGS. 8 and 9, spacers may be additionally included as a silicon carbide raw material. The spacers may be disposed between the silicon carbide blocks.

First spacers 131 may be disposed between the first silicon carbide block 101 and the second silicon carbide block 102. In addition, second spacers 132 may be disposed between the second silicon carbide block 100 and the third silicon carbide block 103.

The spacers may include silicon carbide. The spacers may be made of silicon carbide. The spacers may include 99 % by mass or more of silicon carbide.

In addition, the spacers may be the silicon carbide block 100. That is, the spacers may be silicon carbide lumps having a predetermined size or more.

The first spacers 131 forms a space between the first silicon carbide block 101 and the second silicon carbide block 102. By the first spacers 131, a second flow path 121 is formed between the first silicon carbide block 101 and the second silicon carbide block 102. The second flow path 121 may extend in a horizontal direction.

The second flow path 121 may have a width of about 0.5 mm to about 30 mm. The second flow path 121 may have a width of about 1 mm to about 20 mm. The second flow path 121 may have a width of about 5 mm to about 10 mm. The width of the second flow path 121 may be determined by heights of the first spacers 131.

The second flow path 121 may be connected to the first flow path 120. That is, the second flow path 121 may be connected to the space between the space between the second silicon carbide block 102 and the inner surface of the crucible body 10.

The second spacers 132 form a space between the second silicon carbide block 102 and the third silicon carbide block 103. By the second spacers 132, a third flow path 122 is formed between the second silicon carbide block 102 and the third silicon carbide block 103. The third flow path 122 may extend in a horizontal direction.

The third flow path 122 may have a width of about 0.5 mm to about 30 mm. The third flow path 122 may have a width of about 1 mm to about 20 mm. The third flow path 122 may have a width of about 5 mm to about 10 mm. The width of the third flow path 122 may be determined by heights of the second spacers 132.

The third flow path 122 may be connected to the first flow path 120. That is, the third flow path 122 may be connected to a space between the third silicon carbide block 103 and the inner surface of the crucible body 10.

In addition, although not shown in the drawings, third spacers may be disposed between the first silicon carbide block 101 and the bottom surface of the crucible body 10. The third spacers may form a fourth flow path between the first silicon carbide block 101 and the bottom surface of the crucible body 10.

Inside the crucible body 10, the second flow path 121, the third flow path 122 and the fourth flow path may extend in a direction crossing a vertical direction.

Accordingly, silicon carbide gas from sublimated and generated from a lower surface of the first silicon carbide block 101 and the third spacers may be efficiently transmitted to the seed crystal 110 through the fourth flow path and the first flow path 120.

In addition, silicon carbide gas sublimated from an upper surface of the first silicon carbide block 101, a lower surface of the second silicon carbide block 102 and the first spacers 131 may be efficiently transmitted to the seed crystal 110 through the second flow path 121 and the first flow path 120.

In addition, silicon carbide gas sublimated from an upper surface of the second silicon carbide block 102, a lower surface of the third silicon carbide block 103 and the second spacers 132 may be efficiently transmitted to the seed crystal 110 through the third flow path 122 and the first flow path 120.

The methods of manufacturing the silicon carbide ingot and the silicon carbide wafer according to the embodiment may efficiently transmit the sublimated silicon carbide gas upward in a direction crossing the vertical direction, e.g., using flow paths extending in a horizontal direction.

Therefore, the methods of manufacturing the silicon carbide ingot and the silicon carbide wafer according to the embodiment may provide an ingot and wafer with improved growth rate, fewer defects, and improved crystal properties.

FIG. 10 is a sectional view in which a silicon carbide block is disposed in a crucible assembly according to a sixth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIG. 10, a silicon carbide power may be disposed in the first flow path 120, the second flow path 121 and the third flow path 122. In addition, the silicon carbide power may be packed into the first flow path 120, the second flow path 121 and the third flow path 122.

In addition, although not shown in the drawings, the silicon carbide power may be disposed also in a fourth flow path.

In addition, the first spacers 131, the second spacers 132 and the third spacers may be omitted. That is, the silicon carbide powder may replace the spacer functions of the first spacers 131, the second spacers 132 and the third spacers.

Heat transfer characteristics in each flow path may be improved by the silicon carbide powder, and transfer performance of the sublimated silicon carbide gas may be maintained by spaces between particles included in the silicon carbide powder.

Therefore, the methods of manufacturing the silicon carbide ingot and the silicon carbide wafer according to the embodiment may have a uniform temperature gradient as a whole in the horizontal direction. Accordingly, the methods of manufacturing the silicon carbide ingot and the silicon carbide wafer according to the embodiment may provide an ingot and wafer with improved growth rate, fewer defects, and improved crystal properties.

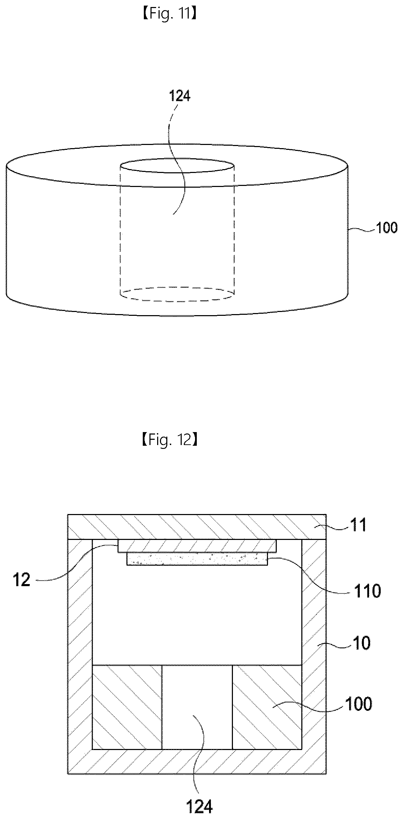

FIG. 11 is a perspective view illustrating a silicon carbide block according to a seventh embodiment. FIG. 12 is a sectional view illustrating a state in which a silicon carbide block is disposed in a crucible assembly according to the seventh embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIGS. 11 and 12, the silicon carbide block 100 includes a fifth flow path 124. The fifth flow path 124 may be formed in a central portion of the silicon carbide block 100. The fifth flow path 124 may be formed to extend upwardly from the inside of the silicon carbide block 100. In addition, the fifth flow path 124 may be opened upwardly from the inside of the silicon carbide block 100.

Here, a depth of the fifth flow path 124 may be about 1/2 to about 1 of a height of the silicon carbide block 100. The depth of the fifth flow path 124 may be about 2/3 to about 9/10 of the height of the silicon carbide block 100. The depth of the fifth flow path 124 may be about 3/4 to about 4/5 of the height of the silicon carbide block 100.

The fifth flow path 124 may penetrate the silicon carbide block 100 in a vertical direction. That is, the fifth flow path 124 may penetrate from a lower surface of the silicon carbide block 100 to an upper surface thereof.

The fifth flow path 124 may have a cylindrical shape. The silicon carbide block 100 may have a donut shape.

A diameter of the fifth flow path 124 may be about 1/10 to about 1/2 of a diameter of the silicon carbide block 100. The diameter of the fifth flow path 124 may be about 1/5 to about 1/3 of the diameter of the silicon carbide block 100. The diameter of the fifth flow path 124 may be about 3/10 to about 1/2 of the diameter of the silicon carbide block 100.

In addition, the diameter of the fifth flow path 124 may be about 1 cm to about 30 cm. The diameter of the fifth flow path 124 may be about 3 cm to about 20 cm. The diameter of the fifth flow path 124 may be about 5 cm to about 10 cm.

Since the fifth flow path 124 is opened upward, silicon carbide gas sublimated to an inner surface of the fifth flow path 124 may be efficiently transmitted upward. In addition, the inner surface of the fifth flow path 124 may be disposed along the inner surface of the crucible body 10. Accordingly, heat from the crucible body 10 may be uniformly transmitted to the inner surface of the fifth flow path 124. That is, an interval between the inner surface of the fifth flow path 124 and the inner surface of the crucible body 10 may be uniform depending on the position, and heat from the crucible body 10 may be uniformly transmitted to the inner surface of the fifth flow path 124.

Therefore, the methods of manufacturing the silicon carbide ingot and the silicon carbide wafer may uniformly control the temperature of the inner surface of the fifth flow path 124. In addition, the methods of manufacturing the silicon carbide ingot and the silicon carbide wafer may efficiently sublimate the silicon carbide gas from the inner surface of the fifth flow path 124.

Accordingly, the methods of manufacturing the silicon carbide ingot and the silicon carbide wafer according to the embodiment may provide an ingot and wafer with improved growth rate, fewer defects, and improved crystal properties.

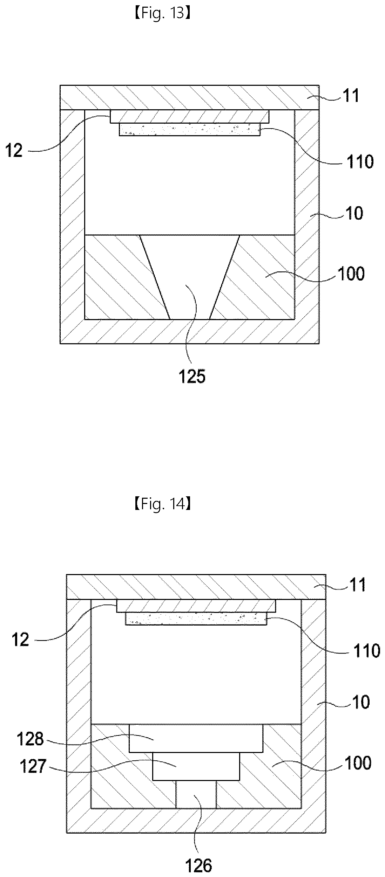

FIG. 13 is a sectional view illustrating a state in which a silicon carbide block is disposed in a crucible assembly according to an eighth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIG. 13, the silicon carbide block 100 includes a sixth flow path 125. The sixth flow path 125 may be formed in a central portion of the silicon carbide block 100. The sixth flow path 125 may be formed to extend upwardly from the inside of the silicon carbide block 100. In addition, the sixth flow path 125 may be opened upwardly from the inside of the silicon carbide block 100.

Here, a depth of the sixth flow path 125 may be about 1/2 to about 1 of the height of the silicon carbide block 100. The depth of the sixth flow path 125 may be about 2/3 to about 9/10 of the height of the silicon carbide block 100. The depth of the sixth flow path 125 may be about 3/4 to about 4/5 of the height of the silicon carbide block 100.

In addition, the sixth flow path 125 may have an average inner diameter of about 1 cm to about 30 cm. The sixth flow path 125 may have an average inner diameter of about 3 cm to about 20 cm. The sixth flow path 125 may have an average inner diameter of about 5 cm to about 10 cm.

The sixth flow path 125 may penetrate the silicon carbide block 100 in a vertical direction. That is, the sixth flow path 125 may penetrate from the lower surface of the silicon carbide block 100 to the upper surface thereof.

In addition, an inner surface of the sixth flow path 125 may be inclined in a vertical direction. The sixth flow path 125 may have an inner diameter that gradually increases toward an upper side. Here, the inner diameter of the flow path means the diameter of a circle having the same area as the sectional area of the flow path in a horizontal direction of the flow path. The inner surface of the sixth flow path 125 may have an average inclination of 0.5 to 10. The inner surface of the sixth flow path 125 may have an average inclination of about 1 to about 5. The inner surface of the sixth flow path 125 may have an average inclination of about 1.5 to about 3.

Here, the average inclination is a value obtained by dividing the depth of the sixth flow path 125 by a difference between the inner diameter of the lowest portion of the sixth flow path 125 and the inner diameter of the highest portion of the sixth flow path 125. The average inclination may be expressed by Equation 1 below. Depth of flow path / (Inner diameter of highest portion of flow path - Inner diameter of lowest portion of flow path)

The sixth flow path 125 may have a truncated cone shape. The sixth flow path 125 may have a truncated polygonal pyramid shape. The inner diameter of the sixth flow path 125 may have a tendency to gradually increase upward.

Since the sixth flow path 125 is opened upward, the silicon carbide gas sublimated to the inner surface of the sixth flow path 125 may be efficiently transmitted upward. In addition, the inner surface of the sixth flow path 125 is inclined, thereby having a large surface area.

In addition, the induction coil 40 may reduce applied heat as it goes to the upper part of the crucible body 10 from the lower part of the crucible body 10 in a region where the silicon carbide block 100 is disposed. Accordingly, even if the inner surface of the sixth flow path 125 is inclined, the temperature of the inner surface of the sixth flow path 125 may be uniformly controlled.

Therefore, the methods of manufacturing the silicon carbide ingot and the silicon carbide wafer may increase the amount of silicon carbide gas sublimated from the inner surface of the sixth flow path 125.

Accordingly, the methods of manufacturing the silicon carbide ingot and the silicon carbide wafer according to the embodiment may provide an ingot and wafer with improved growth rate, fewer defects, and improved crystal properties.

FIG. 14 is a sectional view illustrating a state in which a silicon carbide block is disposed in a crucible assembly according to a ninth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIG. 14, a flow path formed in a central portion of the silicon carbide block 100 may have a step shape. An inner surface of the flow path may have a step shape. The inner surface of the flow path may have a step.

The silicon carbide block 100 may include a seventh flow path 126, an eighth flow path 127 and a ninth flow path 128.
the seventh flow path 126 is disposed in the lower part of the silicon carbide block 100. The seventh flow path 126 is disposed to be adjacent to a lower surface of the silicon carbide block 100. The seventh flow path may penetrate the lower surface of the silicon carbide block 100.

The eighth flow path 127 is connected to the seventh flow path 126 and disposed on the seventh flow path 126.

The ninth flow path 128 is disposed on the eighth flow path 127. In addition, the ninth flow path 128 is connected to the eighth flow path 127. The ninth flow path 128 is disposed in an upper part of the silicon carbide block 100. The ninth flow path 128 penetrates the upper surface of the silicon carbide block 100. The ninth flow path 128 is opened upward from the upper surface of the silicon carbide block 100.

An average inner diameter of the ninth flow path 128 is larger than an average inner diameter of the eighth flow path 127. In addition, the average inner diameter of the eighth flow path 127 is larger than the average inner diameter of the ninth flow path 128.

The average inner diameter of the ninth flow path 128 may be about 1.1 times to about 2 times larger than the average inner diameter of the eighth flow path 127. In addition, the average inner diameter of the eighth flow path 127 may be about 1.1 times to about 2 times larger than an average inner diameter of the seventh flow path 126.

Since the ninth flow path 128 is opened upward, the seventh flow path 126, silicon carbide gas sublimated to the inner surfaces of the eighth flow path 127 and the ninth flow path 128 may be efficiently transmitted upward. In addition, the inner surfaces of the seventh flow path 126, the eighth flow path 127 and the ninth flow path 128 have a step, thereby having a large surface area.

In addition, the induction coil 40 may reduce applied heat as it goes to the upper part of the crucible body 10 from the lower part of the crucible body 10 in a region where the silicon carbide block 100 is disposed. Accordingly, even if the inner surfaces of the seventh flow path 126, the eighth flow path 127 and the ninth flow path 128 have a step, the temperature of the inner surfaces of the seventh flow path 126, the eighth flow path 127 and the ninth flow path 128 may be uniformly controlled.

Therefore, the methods of manufacturing the silicon carbide ingot and the silicon carbide wafer may increase the amount of silicon carbide gas sublimated from the inner surface of the sixth flow path 125.

Accordingly, the methods of manufacturing the silicon carbide ingot and the silicon carbide wafer according to the embodiment may provide an ingot and wafer with improved growth rate, fewer defects, and improved crystal properties.

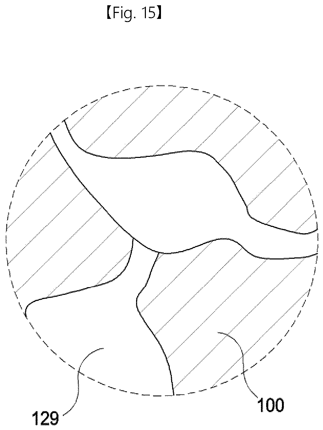

FIG. 15 is a sectional view illustrating a cross-section of a silicon carbide block according to a tenth embodiment. The description of this embodiment refers to the description of the method of manufacturing the silicon carbide ingot and the wafer provided above, and changed parts are additionally described. The description of the previous embodiments may be essentially combined with the description of this embodiment except for the changed parts.

Referring to FIG. 15, the silicon carbide block 100 may have a micropore 129. The micropore 129 may have an inner diameter of about 1 µm to about 500 µm. The micropore 129 is an open pore. That is, the micropore 129 may be opened to the outside of the silicon carbide block 100. In addition, the micropore 129 may be connected to the silicon carbide block 100, even up to the inside of the silicon carbide block 100.

To form the micropore 129, the silicon carbide block 100 may be formed by sintering. That is, a silicon carbide power may be packed in a desired shape and sintered to form the silicon carbide block 100. In the sintering process, particles included in the silicon carbide powder may be connected to each other to form the silicon carbide block 100. In addition, in the sintering process, a space between particles included in the silicon carbide powder may form the micropore 129.

In addition, spacers may also have a structure similar to that of the silicon carbide block 100. That is, the spacers may also include the micropore 129.

Since the silicon carbide block 100 is formed by connecting silicon carbide particles to each other, high thermal conductivity is exhibited. In addition, due to inclusion of the micropores 129, sublimated silicon carbide gas may be efficiently discharged.

Therefore, the methods of manufacturing the silicon carbide ingot and the silicon carbide wafer may increase the amount of silicon carbide gas sublimated from the inner surface of the micropore 129.

Accordingly, the methods of manufacturing the silicon carbide ingot and the silicon carbide wafer according to the embodiment may provide an ingot and wafer with improved growth rate, fewer defects, and improved crystal properties.

The embodiments described above may be combined with each other so long as they do not technically interfere with each other. For example, the silicon carbide power may also be disposed in the fourth flow path, the fifth flow path 124, the sixth flow path 125, the seventh flow path 126, the eighth flow path 127 and the ninth flow path 128. In addition, the silicon carbide power may also be disposed in a space between the silicon carbide blocks 100. In addition, the spacers may be disposed at various positions to form a flow path.

Hereinafter, embodiments are described in more detail through specific examples. The following examples are merely examples to aid understanding of the embodiments, and the scope of the invention disclosed in the present specification is not limited thereto.

### Examples 1 to 5 and Comparative Example

A donut-shaped sintered body #1 was loaded inside a graphite crucible body. A silicon carbide seed crystal and a seed crystal holder were placed on the upper part of the silicon carbide block. Here, the silicon carbide seed crystal (4H SiC single crystal, 6 inches) was fixed in a conventional manner such that the C side thereof faces the lower part of a crucible. In addition, a crucible cover and the seed crystal holder were integrally made of graphite. The crucible cover and the seed crystal holder both had a disk shape.

A main body of the crucible was covered with a crucible cover in which the seed crystal and a seed crystal holder were installed, surrounded by a heat-insulating material, and placed in a reaction chamber equipped with a heating coil as a heating means.

Here, graphite felt having a density of 0.19 g/cc, a porosity of 85%, and a compressive strength of 0.37 MPa was used as the heat-insulating material.

After making the inside of the crucible in a vacuum state, argon gas was slowly injected such that the inside of the crucible reached atmospheric pressure, and the inside of the crucible was gradually decompressed again. At the same time, the temperature inside the crucible was gradually increased to 2000°C at a temperature increase rate of about 5°C/min, and gradually increased to 2350°C at a temperature increase rate of about 3°C/min.

Next, a SiC ingot was grown from a silicon carbide seed crystal for 100 hours under conditions of a temperature 2350°C and a pressure of 20 torr.

Next, the silicon carbide ingot was cut by a diamond wire saw, and processed by a chamfering process, a grinding process, and a polishing process. Accordingly, a silicon carbide wafer having an off angle of 4 degrees with respect to the plane (0001) was manufactured.

**[Table 1]**

| Classification | Raw material | Growth rate (µm/hr) | Surface fits (number/cm²) | Defects (BPD, TSD, TED, etc.) (number/cm²) |
|---|---|---|---|---|
| Example 1 | Donut-shaped silicon carbide sintered body# 1 | 320 | 4800 | 8000 |
| Example 2 | Donut-shaped silicon carbide sintered body#2 | 260 | 4400 | 8400 |
| Example 3 | Cylindrical silicon carbide sintered body | 330 | 4400 | 8800 |
| Example 4 | Cylindrical polycrystal silicon carbide block | 375 | 5200 | 7200 |
| Example 5 | Cylindrical single-crystal silicon carbide block | 380 | 5200 | 7600 |
| Comparative example | Silicon carbide power | 220 | 5600 | 10400 |

### 1) Donut-shaped silicon carbide sintered body#1

This silicon carbide sintered body was formed by sintering a silicon carbide power having a particle diameter D50 of about 150 µm at about 2200°C for about 5 hours. The formed silicon carbide sintered body had the shape of FIG. 10, an outer diameter of about 175 mm, an inner diameter of about 30 mm, a height of about 80 mm, and a porosity of about 45 vol%.

### 2) Donut-shaped silicon carbide sintered body#2

This silicon carbide sintered body was formed by sintering a silicon carbide power having D50 of about 150 µm at about 2200°C for about 5 hours. The formed silicon carbide sintered body had the silicon carbide block shape of FIG. 13, an outer diameter of about 170 mm, a height of about 80 mm, a smallest inner diameter of about 30 mm, a largest inner diameter of about 100 mm, and a porosity of about 46 vol%.

### 3) Cylindrical silicon carbide sintered body

This silicon carbide sintered body was formed by sintering a powder having D50 of about 150 µm at about 2200°C for about 5 hours. The formed silicon carbide sintered body had an outer diameter of about 170 mm, a height of about 80 mm, and a porosity of about 43 vol%.

### 4) Cylindrical polycrystal silicon carbide block

This polycrystal silicon carbide block had an outer diameter of about 170 mm and a height of about 80 mm.

### 5) Cylindrical single-crystal silicon carbide block

This single-crystal silicon carbide block had an outer diameter of about 170 mm and a height of about 80 mm.

### 6) Silicon carbide power

This silicon carbide power had D50 of about 150 µm.

The methods of manufacturing a silicon carbide ingot and a wafer according to the embodiments provide an improved growth rate and exhibit low defects.

While exemplary embodiments of the present invention have been described in detail, the scope of the present invention is not limited thereto, and various modifications and improvements made by those of ordinary skill in the art using the basic concept of the present invention as defined in the following claims fall within the scope of the present invention.

### [Description of Reference Numerals]

silicon carbide block 100
crucible body 10
crucible cover 11
seed crystal holder 12
seed crystal 110
silicon carbide ingot 111

## Claims

1. A method of manufacturing a silicon carbide wafer, the method comprising:
disposing a silicon carbide block in a crucible;
sublimating a silicon carbide comprised in the silicon carbide block to form a silicon carbide ingot; and
processing the silicon carbide ingot.

2. The method according to claim 1, wherein the silicon carbide block has an apparent volume of about 1 cm³ or more.

3. The method according to claim 1, wherein the silicon carbide block has a thermal conductivity of about 10 W/mK or more in at least one direction.

4. The method according to claim 1, wherein a flow path through which a sublimated silicon carbide gas can move is formed between an outer peripheral surface of the silicon carbide block and an inner surface of a reaction vessel.

5. The method according to claim 1, wherein the silicon carbide block is disposed to have a thermal conductivity of 10 W/mK or more in a horizontal direction.

6. The method according to claim 1, wherein the silicon carbide block comprises a flow path through which a sublimated silicon carbide gas can move.

7. The method according to claim 6, wherein the flow path is opened upward.

8. The method according to claim 7, wherein at least a portion of the flow path has an inner diameter that gradually increases toward an upper direction.

9. The method according to claim 6, wherein the flow path comprises:
a first flow path having a first inner diameter; and
a second flow path connected to the first flow path and configured to have a second inner diameter larger than the first inner diameter,
wherein the second flow path is disposed on the first flow path.

10. The method according to claim 1, wherein the silicon carbide block comprises:
a first silicon carbide block disposed in the reaction vessel; and
a second silicon carbide block disposed on the first silicon carbide block.

11. The method according to claim 10, wherein a flow path through which a sublimated silicon carbide gas can pass is formed between the first silicon carbide block and the second silicon carbide block.

12. The method according to claim 11, wherein a silicon carbide power is disposed in the flow path.

13. The method according to claim 1, wherein the silicon carbide block has a cylindrical shape, a cone shape, a donut shape, or a polygonal pillar shape.

14. The method according to claim 1, wherein the silicon carbide ingot has a growth rate of 250 µm/hr or more.

15. The method according to claim 1, wherein the silicon carbide block comprises an open pore, and
the silicon carbide block has a porosity of 10 vol% to 50 vol%.

16. A method of manufacturing a silicon carbide ingot, the method comprising:
disposing a silicon carbide block in a crucible;
disposing a seed crystal in the crucible; and
sublimating silicon carbide comprised in the silicon carbide block to grow the seed crystal.
